(19) Europäisches Patentamt
European Patent Office
Office européen des brevets

(11) **EP 4 707 857 A1**

(12) **EUROPEAN PATENT APPLICATION**

(43) Date of publication:
**11.03.2026 Bulletin 2026/11**

(21) Application number: **25198932.3**

(22) Date of filing: **29.08.2025**

(51) International Patent Classification (IPC):
*G01S 7/4863* (2020.01)  *G01S 17/14* (2020.01)
*G01S 17/18* (2020.01)  *G01S 17/894* (2020.01)
*G01S 17/931* (2020.01)  *H04N 25/773* (2023.01)
*H10F 77/00* (2025.01)

(52) Cooperative Patent Classification (CPC):
**G01S 17/931; G01S 7/4863; G01S 17/14;
G01S 17/18; G01S 17/894; H10F 77/959**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **06.09.2024  JP 2024153685**

(71) Applicant: **Canon Kabushiki Kaisha
Tokyo, 146-8501 (JP)**

(72) Inventor: **TAKAHATA, Kotaro
Ohta-ku, Tokyo 146-8501 (JP)**

(74) Representative: **TBK
Bavariaring 4-6
80336 München (DE)**

(54) **DISTANCE MEASURING APPARATUS, DISTANCE MEASURING METHOD, AND COMPUTER PROGRAM**

(57)     A distance measuring apparatus comprises a light emitter for emitting pulsed light in a traveling direction of a movable apparatus, a photoelectric conversion element having a plurality of pixels arranged, each pixel having a first photoelectric conversion unit configured to generate a first photoelectric conversion signal and a second photoelectric conversion unit configured to generate a second photoelectric conversion signal, wherein the first photoelectric conversion signal and the second photoelectric conversion signal have a predetermined parallax, a visibility condition determination means for determining a visibility condition of the traveling direction, and a control means for switching whether the range gate control is performed or not, based on the visibility condition, when calculation of a distance to an object using the first photoelectric conversion signal and the second photoelectric conversion signal.

FIG. 8

```
                    START
                      │
                      ▼
        ┌──────────────────────────┐  S101
        │ ACQUIRE WEATHER          │
        │ INFORMATION AHEAD        │
        │ OF VEHICLE               │
        └──────────────────────────┘
                      │
                      ▼
                 ╱─────────╲  S102
                ╱ BAD       ╲_____ NO _____
                ╲ WEATHER?  ╱                           │
                 ╲─────────╱                            │
                   │ YES                                │
                   ▼  S105                              ▼  S103
        ┌──────────────────────┐           ┌──────────────────────┐
        │ START IMAGE CAPTURING│           │ START IMAGE CAPTURING│
        │ SURFACE PHASE        │           │ SURFACE PHASE        │
        │ DIFFERENCE RANGE     │           │ DIFFERENCE DISTANCE  │
        │ GATE DISTANCE        │           │ MEASURING MODE       │
        └──────────────────────┘           └──────────────────────┘
                   │  S106                              │  S104
                   ▼                                    ▼
        ┌──────────────────────┐           ┌──────────────────────┐
        │ ACQUIRE RANGE GATE   │           │ ACQUIRE IMAGE SIGNAL │
        │ IMAGE SIGNAL         │           │                      │
        └──────────────────────┘           └──────────────────────┘
                   │                                    │
                   └──────────────┬─────────────────────┘
                                  ▼
                   ┌──────────────────────┐  S107
                   │ IMAGE PROCESSING     │
                   └──────────────────────┘
                                  │
                                  ▼
                   ┌──────────────────────────────┐  S108
                   │ CALCULATE PARALLAX AMOUNT,    │
                   │ CONVERT TO DISTANCE VALUE,    │
                   │ GENERATE IMAGE BASED ON       │
                   │ DISTANCE VALUE                │
                   └──────────────────────────────┘
                                  │
                                  ▼
                            ╱─────────╲  S109
                    NO _____╱ DRIVING  ╲
                           ╲ FINISHED? ╱
                            ╲─────────╱
                                │ YES
                                ▼
                              END
```

**Description**

TECHNICAL FIELD

The present disclosure relates to a distance measuring apparatus, a distance measuring method, a computer program, and the like.

BACKGROUND

As an apparatus that performs distance measurement to an object, a distance measuring camera system using the triangulation principle is mounted in many automobiles for the purpose of realization of Advanced Driver Assistance System (ADAS) functionality. Examples of the distance measuring camera system include a stereo camera system and an image capturing surface phase difference distance measuring system.

The stereo camera system arranges two cameras separated by a predetermined interval (baseline length) in parallel, detects an amount of deviation caused by parallax of the object captured in images captured using each of the cameras, and calculates a distance to the object based on the amount of deviation.

The image capturing surface phase difference distance measuring system is a system configured to perform image capturing and perform distance measurement using a single camera provided with an image capturing element called an image capturing surface phase difference image capturing element. That is, two images having a phase difference are generated by photoelectrically converting light that has passed through different pupils of an imaging optical system

using a plurality of photoelectric conversion units on the image capturing surface phase difference image capturing element, and a distance to the object is calculated based on the above-described phase difference.

These distance measuring camera systems may incorrectly calculate the distance to the object in bad weather conditions, for example. Bad weather conditions refer to, for example, situations in which particles of rain, fog, snow, and the like hinder visibility of the object.

In the above-described distance measuring camera system, if light scattered by particles located in front of the object is captured by the camera, image signals corresponding to objects other than the target object are generated. As a result, there are cases in which the distance to the object cannot be accurately calculated due to the influence of the image signals.

In contrast, Japanese Patent No. 6293134 discloses a configuration in which each camera acquires images clearly capturing only subjects in a certain distance range by performing range gate control on a light source and a stereo camera. Range gate control emits pulsed light at a predetermined cycle in front of the camera, and the image capturing element inside the camera performs an exposure operation (accumulation operation) at a predetermined timing according to the target distance. Thereby, clear image capturing of only the object at the target distance can be performed.

Japanese Patent No. 6293134 further discloses that, by thus performing range gate control on two cameras as described above, an amount of deviation caused by parallax of the object captured in each acquired range gate image is detected, and the distance to the object is calculated based on this. By using this technology, the distance to the object can be accurately calculated even in bad weather conditions.

However, in the technology of Japanese Patent No. 6293134 described above, synchronization of images acquired using two cameras on the order of nanoseconds is necessary in order to measure distance to the object with high accuracy under bad weather conditions. For example, in order to acquire a range gate image of a target distance range of 3 m, assuming the speed of light is 300,000 km/s, the required exposure time of the camera becomes 20 ns.

Accordingly, two range gate images synchronized on the order of ns become necessary in order to generate a stereo distance measuring image having high accuracy. However, synchronization of two cameras on the order of ns requires wiring length, accuracy of clock phase, and the like, and there is an issue wherein practical application is difficult.

SUMMARY

The present disclosure relates to a distance measuring apparatus comprising: a light emitter for emitting pulsed light in a traveling direction of a movable apparatus, a photoelectric conversion element having a plurality of pixels arranged, each pixel having a first photoelectric conversion unit configured to generate a first photoelectric conversion signal and a second photoelectric conversion unit configured to generate a second photoelectric conversion signal, wherein the first photoelectric conversion signal and the second photoelectric conversion signal have a predetermined parallax, a visibility condition determination means for determining a visibility condition of the traveling direction, and a control means for switching whether the range gate control is performed or not, based on the visibility condition, when calculation of a distance to an object using the first photoelectric conversion signal and the second photoelectric conversion signal.

Further features of the present invention will become apparent from the following description of embodiments with reference to the attached drawings.

BRIEF DESCRIPTION OF THE DRAWINGS

FIG. 1A to FIG. 1D are diagrams showing examples of attachment positions of a camera 100 to a movable apparatus 200 according to a First Embodiment.

FIG. 2A to FIG. 2C are diagrams showing examples of attachment positions of a light emitter 300 on the movable apparatus 200 according to the First Embodiment.

FIG. 3 is a functional block diagram showing a configuration example of the camera 100, the light emitter 300, and the movable apparatus 200 according to the First Embodiment.

FIG. 4A and FIG. 4B are schematic diagrams showing a configuration example of a photoelectric conversion element 102 according to the First Embodiment.

FIG. 5A to FIG. 5D are schematic diagrams for explaining relationships between an object distance and incident light in an image capturing surface phase difference method.

FIG. 6 is a diagram showing progress of light radiated from the light emitter 300 and reflected light thereof, and exposure timing of the camera 100 in range gate control according to the First Embodiment.

FIG. 7 is a timing chart showing an example of light emission and exposure control operations in a one-frame period in range gate control according to the First Embodiment.

FIG. 8 is a flowchart showing an example of image generation processing in a distance measuring method according to the First Embodiment.

FIG. 9A and FIG. 9B are timing charts showing examples of light emission and exposure control operations in a one-frame period in an image capturing surface phase difference range gate distance measuring mode according to the First Embodiment.

FIG. 10A to FIG. 10D are diagrams for explaining examples of composite images generated by an image capturing surface phase difference range gate distance measuring mode according to the First Embodiment.

FIG. 11 is a flowchart showing an example of parallax reliability improvement processing in a distance measuring method according to a Second Embodiment.

FIG. 12A and FIG. 12B are diagrams for explaining a method of determining whether target distance range R information in a range gate image signal according to the Second Embodiment and a distance measurement result of an object according to the image capturing surface phase difference range gate distance measuring mode are in agreement.

FIG. 13 is a diagram showing a configuration example of a photoelectric conversion element 102 according to a Third Embodiment.

FIG. 14 is a schematic diagram showing a configuration example of a photoelectric conversion element 102 including an APD.

FIG. 15 is a diagram showing a configuration example of a circuit substrate 921.

FIG. 16 is a diagram showing an example of an equivalent circuit of a signal processing circuit 1060 according to the Third Embodiment.

FIG. 17 is a diagram schematically showing a relationship between operation of an APD 2010 and an output signal.

DESCRIPTION OF THE EMBODIMENTS

Hereinafter, with reference to the accompanying drawings, favorable modes of the present disclosure will be described using Embodiments. In each diagram, the same reference signs are applied to the same members or elements, and duplicate description will be omitted or simplified.

<First Embodiment>

Hereinafter, an explanation is provided with respect to the First Embodiment of the present disclosure. In the First Embodiment, although a camera 100 and a light emitter 300 are attached to a movable apparatus 200 such as a vehicle, the attachment configuration is not limited thereto. It should be noted that details of the camera 100 and the light emitter 300, and the movable apparatus 200 are described below.

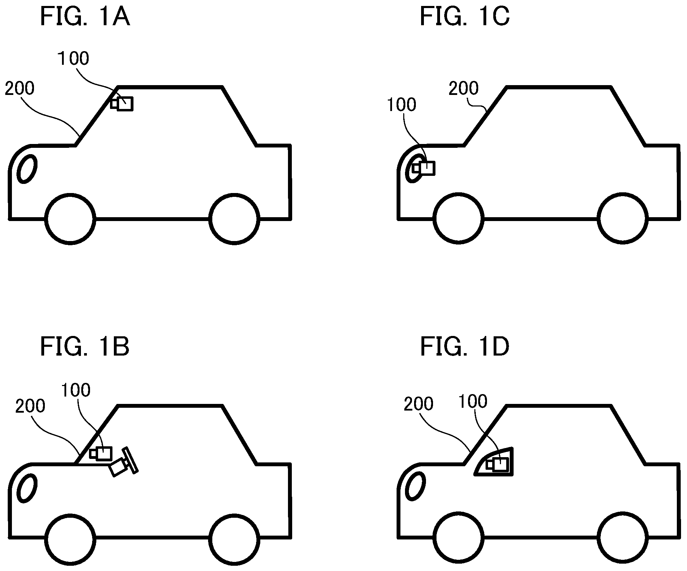

FIG. 1A to FIG. 1D are diagrams showing examples of attachment positions of the camera 100 to the movable apparatus 200 according to the First Embodiment. The camera 100 may be attached to an interior of the movable apparatus 200, for example, an interior side of a front window of the movable apparatus 200 as shown in FIG. 1A, or on a dashboard as shown in FIG. 1B.

In addition, the camera 100 may be attached to an exterior of the movable apparatus 200, for example, a headlamp peripheral portion of the movable apparatus 200 as shown in FIG. 1C, or for example, a side mirror peripheral portion as shown in FIG. 1D.

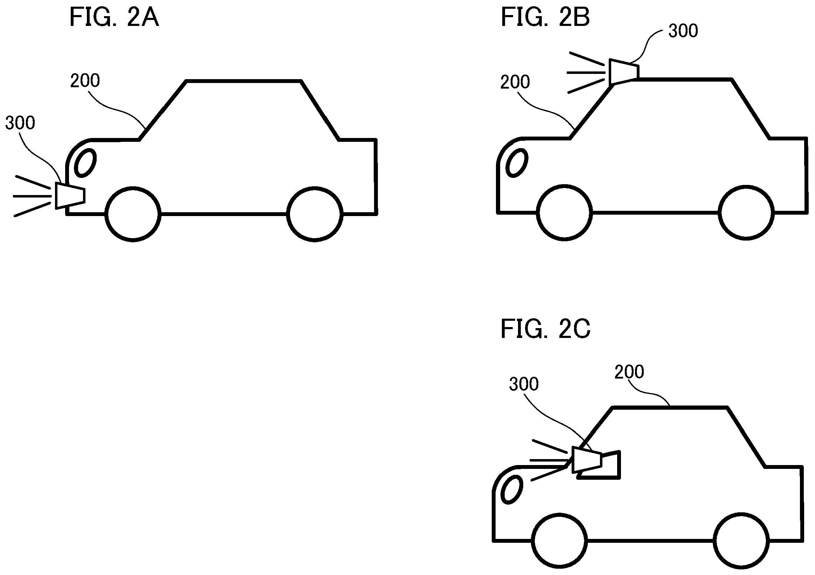

FIG. 2A to FIG. 2C are diagrams showing examples of attachment positions of the light emitter 300 on the movable apparatus 200 according to the First Embodiment. The light emitter 300 may be attached to a headlamp peripheral portion of the movable apparatus 200 as shown in FIG. 2A, a roof portion as shown in FIG. 2B, or a side mirror peripheral portion as shown in FIG. 2C.

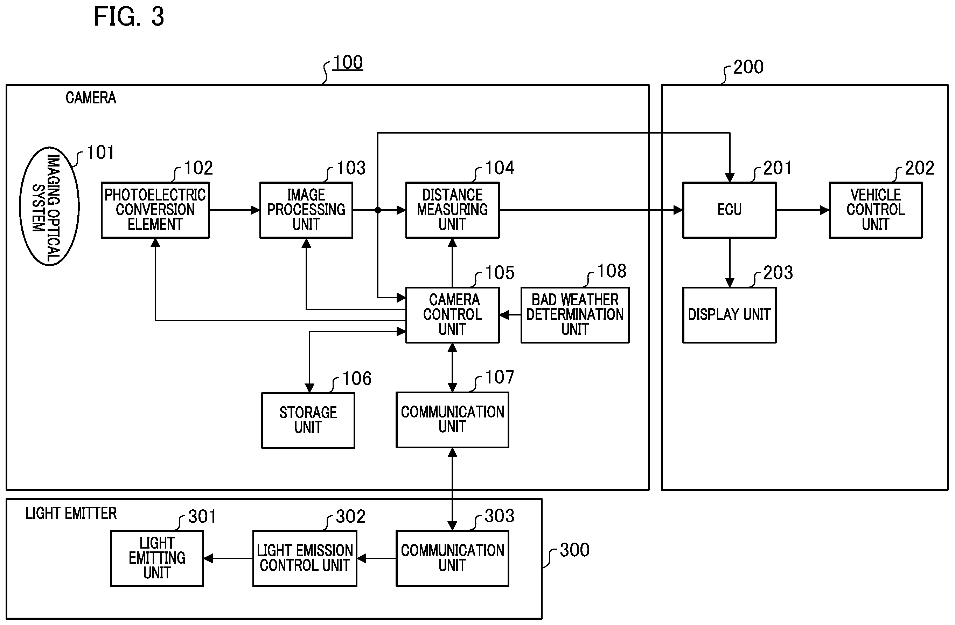

FIG. 3 is a functional block diagram showing a configuration example of the camera 100, the light emitter 300, and the movable apparatus 200 according to the First Embodiment. It should be noted that a part of the functional blocks shown in FIG. 3 is realized by executing a computer program stored in a memory serving as a storage medium (not shown) in a computer (not shown) included in each of the camera 100, the light emitter 300, and the movable apparatus 200.

However, a part or all of the functional blocks may be implemented by hardware. Hardware, dedicated circuits (ASIC), processors (reconfigurable processor, DSP), and the like may be used. In addition, each of the functional blocks shown in FIG. 3 need not be incorporated in the same housing, and may be configured by separate apparatuses connected to each other via signal paths.

The camera 100 includes an imaging optical system 101, a photoelectric conversion element 102, an image processing unit 103, a distance measuring unit 104, a camera control unit 105, a storage unit 106, a communication unit 107, a bad weather determination unit 108, and the like.

The imaging optical system 101 forms an image (optical image) of an object on the photoelectric conversion element 102, and has an exit pupil at a position separated from the photoelectric conversion element 102 by a predetermined distance.

The photoelectric conversion element 102 is a semiconductor image sensor element such as a CMOS (Complementary Metal Oxide Semiconductor) sensor and the like. The photoelectric conversion element 102 is provided with a pixel region in which a plurality of pixels having a photoelectric conversion function are arranged in two dimensions, and each pixel region has a microlens and two photoelectric conversion units.

An object image formed on the photoelectric conversion element 102 via the microlens is photoelectrically converted by the two photoelectric conversion units to generate a first photoelectric conversion signal and a second photoelectric conversion signal, respectively. It should be noted that one of the two photoelectric conversion units receives light from one exit pupil of the imaging optical system, and the other photoelectric conversion unit receives light from a different exit pupil of the imaging optical system.

The image processing unit 103 performs image processing such as black level correction, gamma curve adjustment, noise reduction, digital gain adjustment, demosaic processing, data compression, and the like on an image signal output from the photoelectric conversion element 102, and generates a final image signal. The output of the image processing unit 103 is supplied to the distance measuring unit 104 and the camera control unit 105, and is also supplied to an ECU 201 (Electric Control Unit) of the movable apparatus 200.

The distance measuring unit 104 performs recognition processing of objects such as surrounding people, vehicles, and the like by performing image recognition based on the image signal supplied from the image processing unit 103. In addition, the distance measuring unit 104 calculates a distance to the object based on a phase difference (deviation due to parallax) of the first photoelectric conversion signal and the second photoelectric conversion signal supplied from the image processing unit 103.

The camera control unit 105 incorporates a CPU serving as a computer, and a memory storing a computer program, and the camera control unit 105 performs control of each unit of the camera 100 by the CPU executing the computer program stored in the memory.

It should be noted that the camera control unit 105 functions as a control unit, and performs timing control of the length of an exposure period (charge accumulation period) of each frame and various control signals, and the like by transmitting a reference clock signal that is repeatedly output at predetermined intervals to the photoelectric conversion element 102 and the like. In addition, the camera control unit 105 transmits the reference clock signal and control signals to the light emitter 300 via the communication unit 107.

The storage unit 106 includes a recording medium such as a memory card, a hard disk, and the like, and can store and read out image signals.

The communication unit 107 includes a wireless or wired interface, outputs image signals generated to the outside of the camera 100, and receives various signals from the outside. The bad weather determination unit 108 determines a visibility condition according to weather conditions and the like around the front of the movable apparatus 200, and outputs a determination result to the camera control unit 105. That is, the bad weather determination unit 108 functions as a visibility condition determination unit that determines the visibility condition (such as fog, rain, snow, and the like) in the traveling direction of the movable apparatus.

Weather conditions may be acquired based on weather information obtained from the web and position information of the movable apparatus 200 based on GPS. Alternatively, technologies described in Japanese Patent Application Laid-Open No. 2008-33872 may be used. That is, the bad weather condition may be acquired based on a brightness difference between a range directly illuminated by headlights of the movable apparatus 200 and a range not directly illuminated, captured by the camera 100 attached to the movable apparatus 200.

The light emitter 300 includes a light emitting unit 301, a light emission control unit 302, and a communication unit 303. The communication unit 303 communicates with the communication unit 107 of the camera 100, receives setting information, control signals, and reference clock signals from the camera control unit 105 to the light emission control unit 302, and supplies the setting information, control signals, and reference clock signals to the light emission control unit 302.

The light emission control unit 302 receives the reference clock signal transmitted by the camera control unit 105 of the camera 100 via the communication unit 303, generates a pulse signal at a predetermined timing based on the reference clock signal, and outputs the pulse signal to the light emitting unit 301.

Here, the light emission control unit 302 is capable of setting a period from the reference clock signal until outputting a pulse, a pulse output width, a pulse non-output width, and a repetition cycle from a pulse output to a next pulse output, a number of repetitions, and the like.

When the camera control unit 105 transmits a predetermined control signal to the light emission control unit 302 via the communication unit 107 and the communication unit 303, a pulse signal is output to the light emitting unit 301 at a predetermined timing based on the reference clock signal, and a light emission period of the light emitter 300 is controlled. In this manner, the light emission control unit 302 is emission-controlled in synchronization with the reference clock signal input to the camera 100.

The light emitting unit 301 is, for example, a near-infrared LED disposed at the front of the movable apparatus 200, and is configured by a lens and a light emitting unit. That is, the light emitter 300 can emit pulsed light in the traveling direction of the movable apparatus. It should be noted that, in the present embodiment, the camera control unit 105 functions as a control unit that performs range gate control of a light emission time of the light emitter, an exposure time of the photoelectric conversion element, and an exposure timing. In the following embodiments, the exposure time and the exposure timing respectively mean a photoelectric conversion time and a photoelectric conversion timing.

It should be noted that the frequency band of light irradiated by the light emitting unit 301 is not limited thereto, and may be, for example, in the visible light region. That is, the light emitted by the light emitter is visible light or non-visible light. In addition, the light emitting unit 301 may be a light emitter provided on the movable apparatus 200, such as a headlight. The light emitting unit 301 outputs pulsed light for a predetermined light emission time in accordance with the pulse signal output from the light emission control unit 302.

In this manner, the same reference clock signal supplied to the photoelectric conversion element 102 is also transmitted to the light emitter 300, and the light emitter 300 executes light emission control based on the reference clock signal. Thereby, an exposure (charge accumulation) timing of the photoelectric conversion element 102 and light emission timing by the light emitter 300 are synchronized.

The ECU 201 of the movable apparatus 200 incorporates a CPU serving as a computer and a memory storing a computer program. In addition, the ECU 201 performs control of each unit in the movable apparatus 200, such as a vehicle control unit 202 and the like, by the CPU executing the computer program stored in the memory.

The output of the distance measuring unit 104 is supplied to the vehicle control unit 202 and a display unit 203 via the ECU 201. The vehicle control unit 202 functions as a movement control unit that performs driving, stopping, direction control, and the like of the vehicle serving as the movable apparatus based on the output of the ECU 201.

In addition, the display unit 203 functions as a display means, includes display elements such as a liquid crystal device, an organic EL, and the like, and is mounted on, for example, a dashboard or the like of the movable apparatus 200.

In the present embodiment, the ECU 201 receives information of distance measurement results from the distance measuring unit 104, and is capable of executing vehicle stop control (such as automatic braking and the like) according to the content of the distance measurement results. In addition, the ECU 201 receives distance measurement processing data from the distance measuring unit 104, and transmits the distance measurement processing data to the display unit 203.

Based on the output of the ECU 201, the display unit 203 displays, by using, for example, a GUI, various information to a driver of the movable apparatus 200, including an image generated by the photoelectric conversion element 102, a distance measurement result by the distance measuring unit 104, and a traveling state of the vehicle, and the like.

It should be noted that the image processing unit 103, the distance measuring unit 104, and the like in FIG. 3 need not be mounted on the movable apparatus 200, and may be provided in an external terminal provided separately from the movable apparatus 200 for remotely controlling the movable apparatus 200, or monitoring travel of the movable apparatus.

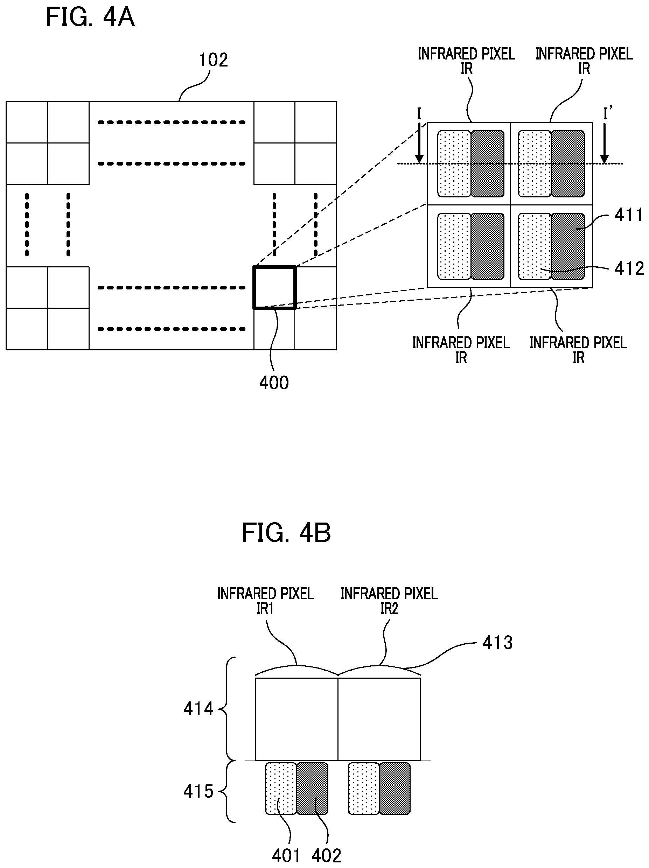

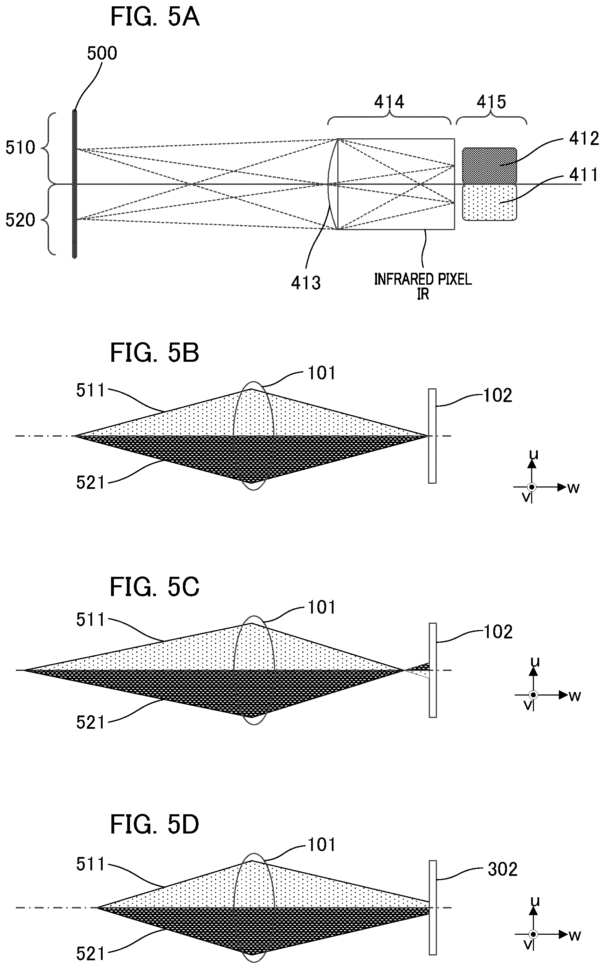

Next, an explanation is provided with respect to a distance measuring principle using the image capturing surface phase difference image capturing element utilizing the photoelectric conversion element 102 by using FIG. 4 and FIG. 5.

FIG. 4A and FIG. 4B are schematic diagrams showing a configuration example of the photoelectric conversion element 102 according to the First Embodiment, and FIG. 4A is a plan view of the photoelectric conversion element 102 viewed from a light incident direction. The photoelectric conversion element 102 is configured by arranging a plurality of 2-row x 2-column pixel groups 400 in a matrix. The pixel group 400 has four infrared pixels IR that detect IR (infrared) light.

It should be noted that the arrangement of each pixel in the pixel group 400 is not limited thereto, and may be changed according to a wavelength band of light emitted from the light emitter 300. The pixel group 400 may be configured by, for example, an infrared pixel IR that detects IR light, a red pixel that detects red color, a green pixel that detects green light, and a blue pixel that detects blue light.

In addition, the pixel group 400 may have two green pixels that detect green color, a red pixel that detects red color, and a blue pixel that detects blue light. In a case in which the above-described pixel arrangement is used, the two green pixels are arranged diagonally.

FIG. 4B is a cross-sectional view taken along line I-I of the pixel group 400 in FIG. 4A. Each pixel has a light guide layer 414, and a light receiving layer 415. The light guide layer 414 has the microlens 413 for efficiently guiding light incident on the pixel to the light receiving layer 415, a color filter that transmits light of a wavelength band detected by each pixel, and wiring for pixel readout and pixel driving.

The light receiving layer 415 is a photoelectric conversion unit that outputs light entered via the light guide layer 414 as an electrical signal by photoelectric conversion. The light receiving layer 415 has a first photoelectric conversion unit 411 and a second photoelectric conversion unit 412. In this manner, each pixel has the first photoelectric conversion unit 411 and the second photoelectric conversion unit 412.

FIG. 5A to FIG. 5D are schematic diagrams for explaining a relationship between a distance of an object and incident light in the image capturing surface phase difference method. FIG. 5A is a schematic diagram showing an exit pupil 500 of the imaging optical system 101, and light incident on each light source conversion unit of an infrared pixel IR of the photoelectric conversion element 102. Although the photoelectric conversion element 102 has a plurality of pixels, for simplification, an explanation is provided with respect to one infrared pixel IR.

The microlens 413 of the infrared pixel IR is arranged so that the exit pupil 500 and the light receiving layer 415 are in an optically conjugate relationship. As a result, light that has passed through a first pupil region 510 that is a partial pupil region included in the exit pupil 500 is incident on the first photoelectric conversion unit 411. Similarly, light that has passed through a second pupil region 520 that is a partial pupil region is incident on the second photoelectric conversion unit 412.

The first photoelectric conversion unit 411 of each pixel outputs a first photoelectric conversion signal by photoelectrically converting received light. A first image signal is generated from the first photoelectric conversion signals output from a plurality of first photoelectric conversion units 411 included in the photoelectric conversion element 102. The first image signal indicates an intensity distribution of an image formed on the photoelectric conversion element 102 by light that has mainly passed through the first pupil region 510.

The second photoelectric conversion unit 412 of each pixel outputs a second photoelectric conversion signal by photoelectrically converting received light. A second image signal is generated from the second photoelectric conversion signals output from a plurality of second photoelectric conversion units 412 included in the photoelectric conversion element 102. The second image signal indicates an intensity distribution of an image formed on the photoelectric conversion element 102 by light that has mainly passed through the second pupil region 520.

In this manner, in the photoelectric conversion element of the present embodiment, a plurality of pixels are arranged, each having a first photoelectric conversion unit that generates a first photoelectric conversion signal and a second photoelectric conversion unit that generates a second photoelectric conversion signal, wherein the first photoelectric conversion signal and the second photoelectric conversion signal have a predetermined parallax.

A relative amount of positional deviation between the first image signal and the second image signal (hereinafter, this is referred to as a parallax amount or a phase difference) corresponds to the defocus amount. An explanation is provided with respect to a relationship between the parallax amount and the defocus amount by using FIG. 5B to FIG. 5D.

FIG. 5B to FIG. 5D are schematic diagrams showing a relationship between the photoelectric conversion element 102, the imaging optical system 101, and an object position. In the figures, reference numeral 511 indicates first light that passes through the first pupil region 510, and reference numeral 521 indicates second light that passes through the second pupil region 520.

FIG. 5B shows a state at the time of focusing, and the first light 511 and the second light 521 converge on the photoelectric conversion unit 102. At this time, a parallax amount between the first image signal formed by the first light 511 and the second image signal formed by the second light 521 becomes 0.

FIG. 5C shows a state defocused in a negative direction of the w axis on the image side. At this time, the parallax amount between the first image signal formed by the first light 511 and the second image signal formed by the second light 521 does not become 0, and has a negative value.

FIG. 5D shows a state that is defocused in the positive direction of the w axis on the image side. At this time, the parallax amount between the first image signal formed by the first light 511 and the second image signal formed by the second light 521 does not become 0, and has a positive value.

From the comparison between FIG. 5C and FIG. 5D, it can be seen that the direction in which parallax occurs is reversed according to the positive or negative of the defocus amount. In addition, from the geometric relationship, it can be understood that a parallax amount according to the defocus amount occurs.

Accordingly, the parallax amount between the first image signal and the second image signal can be detected by a region-based matching method, for example, a block matching method, and converted to a defocus amount. Here, the block matching method is a method in which a region having a high degree of similarity is searched from another image for a certain region selected from one image, and a positional deviation of the region having the high degree of similarity is taken as a parallax.

Furthermore, by using an imaging formula of the imaging optical system 101, the defocus amount on the image side can be converted to a distance to an object. The imaging formula of the imaging optical system 101 is represented by the following Equation (1) when a focal length of the imaging optical system 101 is f, a distance from an image-side principal point to the photoelectric conversion element 102 is Ipp, a defocus amount is $\Delta L$, and a distance to the object is D.

$$D = \frac{1}{\left\{ \frac{1}{f} - 1 \diagup (Ipp + \Delta L) \right\}}$$

(Equation (1))

The above is an explanation of the distance measuring principle using the image capturing surface phase difference method. The distance measuring unit 104 of the present embodiment calculates a distance to the object by operations such as described above based on the first photoelectric conversion signal and the second photoelectric conversion signal.

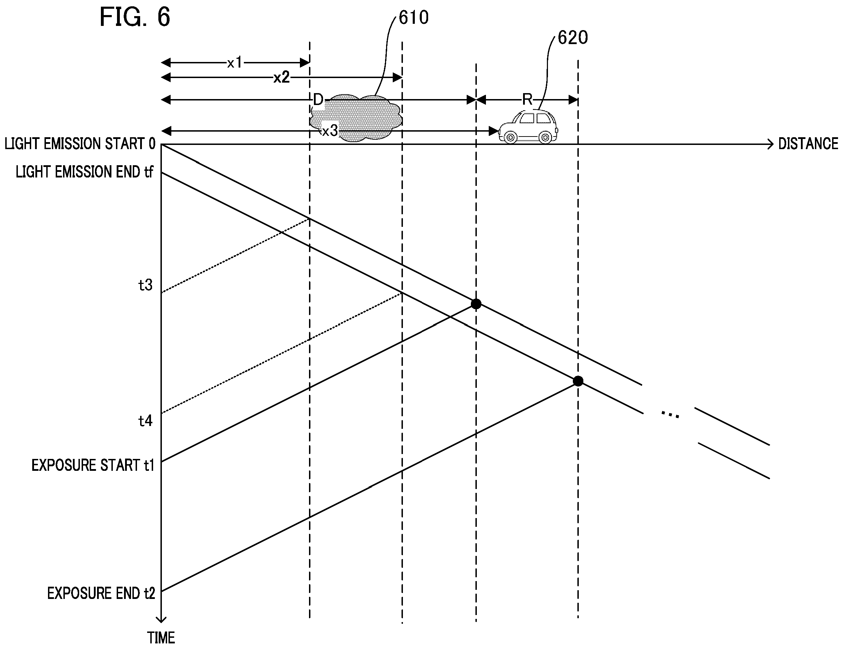

FIG. 6 is a diagram showing progress of light radiated from the light emitter 300 and reflected light thereof, and exposure timing of the camera 100 in range gate control according to the First Embodiment.

By using FIG. 6, an explanation is provided with respect to a method of acquiring an image (range gate image) of a target distance by performing control (range gate control) that synchronizes light emission timing and exposure timing according to the target distance.

It should be noted that a camera that acquires an image of the target distance by range gate control in this manner is called a range gate camera. In FIG. 6, the horizontal axis shows distance, and the vertical axis shows time.

First, an explanation is provided with respect to the horizontal axis. Fog 610 exists between distance x1 and distance x2 due to bad weather, and a vehicle 620 exists at distance x3. In addition, in FIG. 6, in range gate control, a position of distance D serves as a starting point, and from there, a range gate image in a range of target distance range R is acquired.

In this case, the target distance range R becomes a target distance range for which image capturing is desired to be performed. At this time, the vehicle 620 exists within the target distance range R.

Next, an explanation is provided with respect to the vertical axis. Time 0 is set as light emission start timing at the light emitter 300, and time tf is set as light emission end timing. At this time, the light emission period becomes tf.

In addition, in a case in which a position of distance D serves as a starting point, and a range gate image in a range of target distance range R is acquired from there, exposure start time is set as time t1, and exposure end time is set as time t2. It should be noted that in the explanation of the present embodiment, "exposure" means photoelectric conversion in the photoelectric conversion element 102, "exposure start" means photoelectric conversion start, and "exposure end" means photoelectric conversion end.

It should be noted that time t1 is a timing at which radiated light that the light emitter 300 radiated at time 0 has returned to the camera 100 as reflected light from distance D. In addition, t2 is a timing at which radiated light that the light emitter 300 radiated has returned to the camera 100 as reflected light from a location that has advanced by target distance range R from distance D.

In addition, in FIG. 6, a timing at which first reflected light returns to the camera 100 is set as time t3, and a timing at which last reflected light caused by the fog 610 returns to the camera 100 is set as time t4.

In range gate control, exposure is not performed during a period from time t3 to time t4 in which reflected light of the fog 610 reaches the camera 100, and exposure (photoelectric conversion) is performed only during a period from time t1 to time t2 in which reflected light of the portion from distance D to target distance range R arrives. Accordingly, an image of the vehicle 620 can be clearly acquired while removing the fog 610.

Here, an explanation is provided with respect to time until reflected light from an object existing at distance x returns to the camera 100. A timing at which radiated light that started light emission at time 0 hits an object existing at distance x and returns to the image capturing unit as reflected light is set as time tr. At this time, a relationship between timing time tr at which the reflected light returns and distance x to the image capturing object becomes the following Equation (2).

$$\text{Time } tr = 2x/\text{speed of light c (approximately } 3 \times 10^8 \text{ m/s)}$$

As shown in FIG. 6, when distance D to target distance range R is set as the image capturing range, exposure timing time t1 of the starting point of the range can be obtained as the following Equation (3) by substituting distance D for distance x in the above Equation (2).

$$\text{Time } t1 = 2D/\text{speed of light c}$$

$$\text{(Equation (3))}$$

In addition, exposure timing time t2 of the end point of the range can be obtained as the following Equation (4) by substituting distance (D + R) in the above Equation (2) and adding time tf.

$$t2 = tf + 2(D + R)/\text{speed of light c}$$

$$\text{(Equation (4))}$$

In this manner, according to distance x desired to be performed image capturing (target distance range R), time tf from light emission start to light emission end, time t1 from light emission start until exposure start, and time t2 until exposure end are controlled. Thereby, range gate control that can clearly perform image capturing of an object at the target distance even when fog and the like exist between the camera and the target distance is realized.

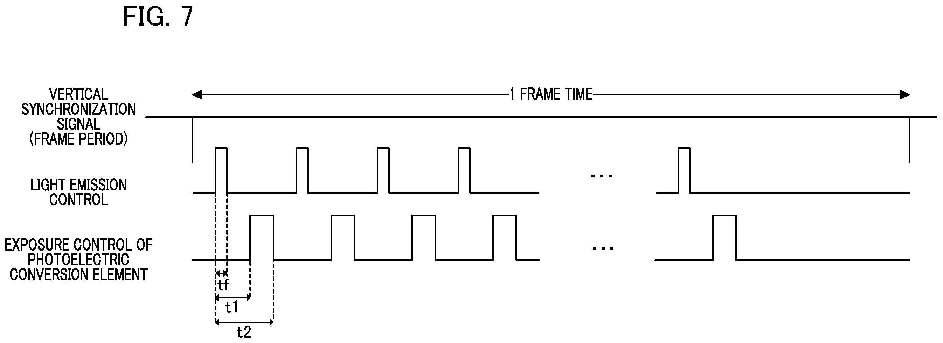

FIG. 7 is a timing chart showing examples of light emission and exposure control operations in a one-frame period in range gate control according to the First Embodiment.

In FIG. 7, "vertical synchronization signal" indicates a frame cycle of image capturing, and a period between a Low pulse and a next Low pulse is a one-frame period. "Light emission control" indicates light emission timing of the light emitter 300, and during a high level, light emission by the light emitter 300 is performed. "Exposure control of the photoelectric conversion element" is an exposure control signal supplied from the camera control circuit, and during a high level, photoelectric conversion in the photoelectric conversion element 102 is performed.

That is, for example, at a rising edge of the exposure control signal, charge accumulation is started by turning off a reset switch (not shown) for resetting charge of the photoelectric conversion unit. Then, at the falling edge of the exposure control signal, charge accumulated in the photoelectric conversion unit is transferred to and held in a memory (not shown) in the pixel, and then the reset switch is turned on again.

In range gate control, the light emission period is controlled in a pulse-like manner as in FIG. 7, and exposure (photoelectric conversion) of the photoelectric conversion element 102 is performed only with respect to reflected light of light from a specific target distance range R.

In FIG. 7, as described above, tf indicates an emission period from emission start to emission end, t1 corresponds to a time from emission start to exposure start, and t2 corresponds to a time from emission start to exposure end. In addition, as described above, t1 indicates a period from emission start until light reaches a specific target distance range R, and reflected light returns to the camera 100.

In addition, as described above, the time from t1 to t2 becomes a period during which reflected light of the specific target distance range R is exposed. In order to correctly perform range gate control, synchronizing timing of light emission start and exposure start according to a range of a predetermined target distance is necessary.

In addition, as described above, in the present embodiment, the camera control unit 105 synchronizes the photoelectric conversion element 102 and the light emission control unit 302 by transmitting the same reference clock signal to the photoelectric conversion element 102 and the light emission control unit 302. A period from light emission start to next light emission start indicated by light emission control on the timing chart becomes a range gate operation cycle.

Then, light exposed by the photoelectric conversion element 102 in one range gate operation cycle is converted to charge and held in a memory in a pixel of the photoelectric conversion element 102.

In that state, as shown in FIG. 7, a next range gate operation cycle is implemented within the same one-frame period, and light newly exposed by the photoelectric conversion element 102 is converted to charge and accumulatively stored in the memory in the pixel of the photoelectric conversion element 102. It should be noted that a period from light emission to the next light emission is set based on a time until the reflected light sufficiently attenuates and no longer returns to the camera 100.

As shown in FIG. 7, the range gate operation cycle is implemented a predetermined plurality of times set within the one-frame period, and charge photoelectrically converted in the last range gate operation cycle within the one-frame period is also further accumulatively stored in the memory in the pixel of the photoelectric conversion element 102.

Thereafter, charge in the memory is read out via a vertical signal line, and thereafter, the charge of the memory is reset by a predetermined switch for reset.

In this manner, in the present embodiment, since the exposure period is synchronized with light emission by the light emitter 300, a clear image can be obtained for a targeted range even under bad weather conditions such as fog. In contrast, range gate control can accurately measure distance only for a target distance range R that depends on an exposure time of the camera 100 and a light emission time of the light emitter 300.

That is, it is necessary to reduce the target distance range in order to improve distance measurement accuracy. Accordingly, reducing the exposure time of the camera 100 and the light emission time of the light emitter 300 is contemplated, although this is difficult due to physical control limitations of the camera 100 and the light emitter 300.

In addition, if range gate image capturing is attempted to a distance after reducing the target distance range R, there is an issue wherein power consumption becomes large because an exposure count of the camera 100 increases. In addition, there is also an issue wherein measuring distance to a far distance takes time.

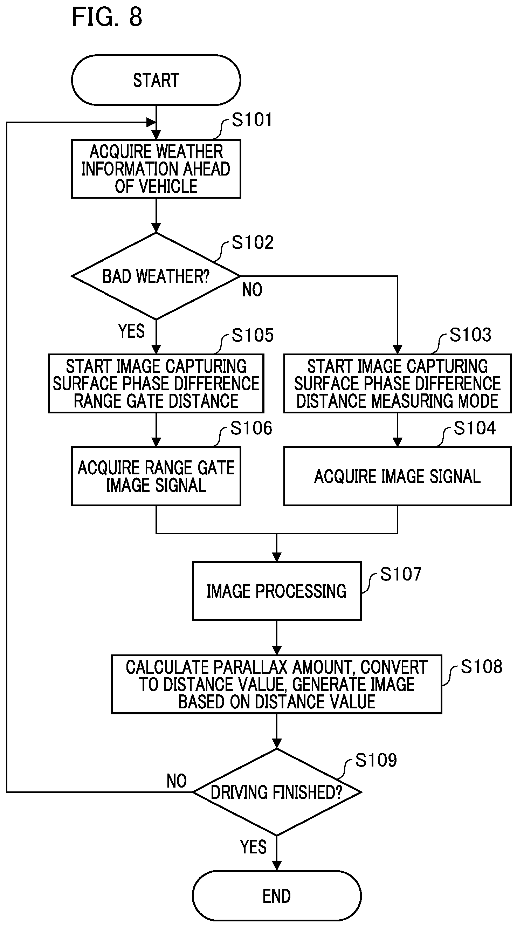

To solve this problem, distance measurement processing in the distance measuring method according to the present embodiment will be described with reference to FIG. 8. FIG. 8 is a flowchart showing an example of image generation processing in a distance measuring method according to the First Embodiment.

It should be noted that operations of each step of the flowchart of FIG. 8 are sequentially performed by a CPU and the like serving as a computer in the camera control unit 105 executing a computer program stored in a memory.

In step S101, the bad weather determination unit 108 acquires weather information regarding the area in front of the movable apparatus 200 during traveling by a method such as described above, and outputs the weather information to the camera control unit 105.

In step S102, the camera control unit 105 determines whether bad weather exists based on the weather information acquired in step S101. In a case in which it is determined that bad weather does not exist in step S102, the process proceeds to step S103.

In step S103, the camera control unit 105 starts the image capturing surface phase difference distance measuring mode, thereby executing the image capturing surface phase difference distance measurement described in FIG. 5A. Here, the image capturing surface phase difference distance measuring mode refers to a mode that generates a first photoelectric conversion signal and a second photoelectric conversion signal during an exposure time set according to brightness of the object.

That is, during only a predetermined exposure period within a one-frame period, the first photoelectric conversion signal is generated by the first photoelectric conversion unit 411 of each pixel of the photoelectric conversion element 102, and the second photoelectric conversion signal is generated by the second photoelectric conversion unit 412 of each pixel of the photoelectric conversion element 102, based on light that has passed through the imaging optical system 101.

It should be noted that the exposure time in step S103 is set according to a luminance signal level of an image up to a previous frame period, for example. The luminance signal level of the image corresponds to brightness of the object.

Subsequently, in step S104, image signals are acquired. That is, a first image signal and a second image signal are acquired based on the first photoelectric conversion signal and the second photoelectric conversion signal of a plurality of pixels. Then, each image signal is output to the image processing unit 103.

In contrast, in a case in which bad weather is determined in step S102, the process proceeds to step S105. In step S105, an image capturing surface phase difference range gate distance measuring mode is started. That is, the camera control unit 105 performs range gate control of the light emitter 300 and the photoelectric conversion element 102. Then, by range gate control, a first photoelectric conversion signal and a second photoelectric conversion signal for a target distance range are generated.

Here, the image capturing surface phase difference range gate distance measuring mode means generating a first photoelectric conversion signal and a second photoelectric conversion signal for a target distance range by range gate control.

In step S106, the camera control unit 105 acquires a first range gate image signal and a second range gate image signal based on the first photoelectric conversion signal and the second photoelectric conversion signal of a plurality of pixels for a specific target distance obtained by range gate control. Then, each range gate image signal is output to the image processing unit 103.

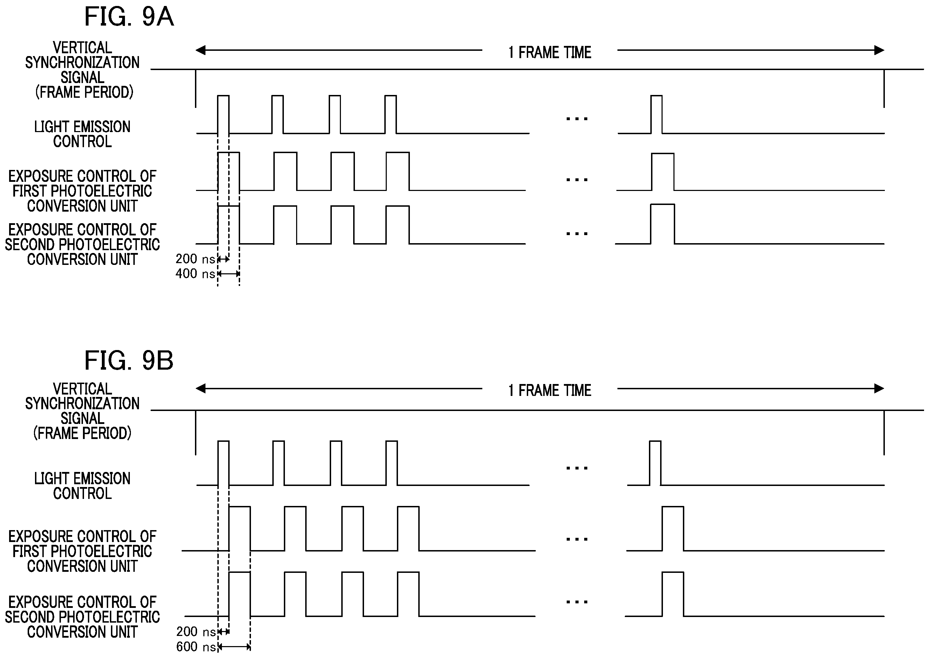

FIG. 9A and FIG. 9B are timing charts showing examples of light emission and exposure control operations in a one-frame period in an image capturing surface phase difference range gate distance measuring mode according to the First Embodiment.

FIG. 9A is a diagram showing an example of light emission timing and exposure timing per one-frame period in a case in which a position of the camera 100 is set as a reference of 0 m, and a target distance range 1 is set as, for example, 0 m to 30 m. It should be noted that the target distance may be changed according to a movement speed of the movable apparatus 200, for example, to become farther as the movement speed becomes faster.

For example, the target distance range 1 is set to 0 m to 30 m. In that case, a light emission time from light emission start to light emission end of the light emitter 300 becomes 200 ns, a time from light emission start to exposure start at the first photoelectric conversion unit 411 and the second photoelectric conversion unit 412 becomes 0 ns, and a time from light emission start to exposure end becomes 400 ns.

In the timing chart of FIG. 9A, a period from light emission start of the light emitter 300 to next light emission start becomes a range gate operation cycle. Light exposed (photoelectrically converted) by the first photoelectric conversion unit 411 and the second photoelectric conversion unit 412 in one range gate operation cycle is converted to charge and separately held in a memory (not shown) in the photoelectric conversion element 102.

In that state, a next range gate operation cycle is implemented, and light newly exposed by the first photoelectric conversion unit 411 and the second photoelectric conversion unit 412 is converted to charge, and separately accumulatively stored in the memory in the photoelectric conversion element 102.

In this manner, a first range gate image signal (A) and a second range gate image signal (A) in the target distance range 0 to 30 m are acquired at each of the first photoelectric conversion unit 411 and the second photoelectric conversion unit 412.

Here, the first range gate image signal (A) refers to an image signal in the target distance range 1 (0 m to 30 m) acquired by performing range gate control of the first photoelectric conversion unit 411. In addition, the second range gate image signal (A) is an image signal in the target distance range 1 (0 m to 30 m) acquired by performing range gate control of the second photoelectric conversion unit 412.

FIG. 9B is a diagram showing an example of light emission timing and exposure timing per one-frame period in a case in which the position of the camera 100 is set as 0 m, and a target distance range 2 is set as, for example, 30 m to 60 m.

The target distance range 2 is set to 30 m to 60 m. In that case, the light emission time from light emission start to light emission end of the light emitter 300 becomes 200 ns, a time from light emission start to exposure start at the first photoelectric conversion unit 411 and the second photoelectric conversion unit 412 becomes 200 ns, and a time from light emission start to exposure end becomes 600 ns.

Similar to FIG. 9A, a period from light emission start of the light emitter 300 to next light emission start in the timing chart becomes a range gate operation cycle. In addition, similar to FIG. 9A, a first range gate image signal (B) and a second range gate image signal (B) in the target distance range 2 (30 m to 60 m) are acquired at each of the first photoelectric conversion unit 411 and the second photoelectric conversion unit 412 in one range gate operation cycle.

The first range gate image signal (B) is an image signal in the target distance range 2 (30 m to 60 m) acquired by performing range gate control of the first photoelectric conversion unit 411. In addition, the second range gate image signal (B) is an image signal in the target distance range 2 (30 m to 60 m) acquired by performing range gate control of the second photoelectric conversion unit 412.

In the present embodiment, in this manner, the plurality of first photoelectric conversion signals generated by performing range gate control a plurality of times are added, and the plurality of second photoelectric conversion signals are added.

In step S107, the image processing unit 103 performs image processing of each image signal acquired in step S104 or step S106. Here, image processing means generating a final image signal by black level correction, gamma curve adjustment, noise reduction, digital gain adjustment, demosaic processing, data compression, and the like.

In step S108, a parallax amount is calculated and converted to a distance value. In addition, an image is generated based on the distance value. That is, the distance measuring unit 104 calculates a parallax amount from each image signal acquired in step S107 based on a distance measuring principle by the image capturing surface phase difference method shown in FIG. 5A, calculates a distance value, and generates a display image based on the distance value. It should be noted that in step S108, image recognition is further performed based on each image signal.

It should be noted that in a case of the image capturing surface phase difference distance measuring mode, in step S108, image recognition is performed based on the first image signal and the second image signal acquired in step S104, and an object distance value is calculated based on a parallax amount of the first image signal and the second image signal.

In contrast, in a case of the image capturing surface phase difference range gate distance measuring mode, in step S108, image recognition is performed based on the first range gate image signal (A) and the second range gate image signal (A) acquired in step S106.

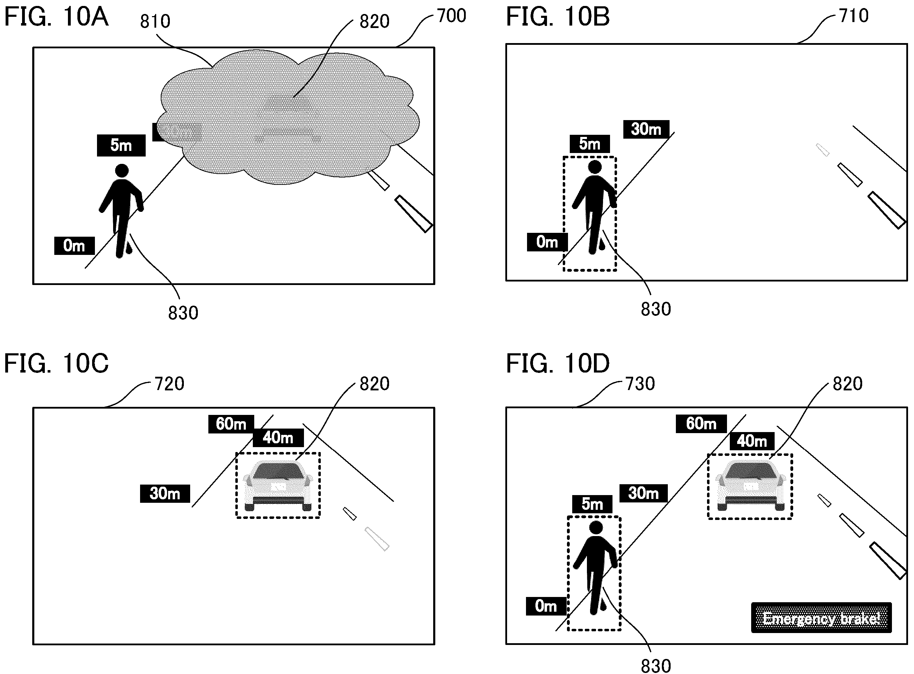

In addition, in step S108, a distance value is calculated based on a parallax amount of the first range gate image signal (A) and the second range gate image signal (A), and an image 710 as shown in FIG. 10B is generated based on the distance value.

It should be noted that the image 710 may be an image obtained by addition synthesis of both the first range gate image signal (A) and the second range gate image signal (A), or may be an image that displays only one of the first range gate image signal (A) and the second range gate image signal (A).

In addition, in step S108, a distance value is calculated based on a parallax amount of the first range gate image signal (B) and the second range gate image signal (B) acquired in step S106 in a similar manner to the above, and an image 720 as shown in FIG. 10C is generated based on the distance value.

It should be noted that the image 720 may be an image obtained by addition synthesis of both the first range gate image signal (B) and the second range gate image signal (B), or may be an image that displays only one of the first range gate image signal (B) and the second range gate image signal (B).

Thereafter, by performing image composition processing of the image 710 and the image 720, a composite image 730 of the 0 to 60 m distance range is generated as shown in FIG. 10D.

Here, image composition is processing for obtaining an image of the 0 to 60 m distance range by superimposing the image 710 in the target distance range R 0 to 30 m and the image 720 in the target distance range R 30 m to 60 m.

FIG. 10A to FIG. 10D are diagrams for explaining examples of composite images generated by the image capturing surface phase difference range gate distance measuring mode according to the First Embodiment.

FIG. 10A shows one example of an image 700 that is not range gate controlled in the present embodiment. That is, FIG. 10A shows, for example, an example of an image generated in the image capturing surface phase difference distance measuring mode of step S103. It should be noted that in a case in which the image is generated in the image capturing surface phase difference distance measuring mode, the image 700 may be an image obtained by addition synthesis of both the first image signal and the second image signal, or may be an image that displays only one of the first image signal and the second image signal.

In FIG. 10A, a pedestrian 830, fog 810, and a vehicle 820 are captured. Although the vehicle 820 exists beyond the fog 810, the vehicle 820 is unclear due to the fog 810 in the image that is not range gate controlled.

Accordingly, the vehicle 820 cannot be accurately measured by distance measurement processing in the distance measuring unit 104. Although the image 700 that is not range gate controlled can perform image capturing of the vehicle 820 and the pedestrian 830 in one frame, the image becomes unclear in bad weather conditions such as fog.

Next, FIG. 10B shows the image 710 in the target distance range 1 (0 m to 30 m) generated by the image capturing surface phase difference range gate distance measuring mode shown in FIG. 9A. The image 710 is subjected to recognition processing by the distance measuring unit 104, and the pedestrian 830 is detected.

In addition, by range gate control of the first photoelectric conversion unit 411 and the second photoelectric conversion unit 412 by the camera control unit 105, correspondence of the image 710 to the target distance range 1 (0 m to 30 m) is understood, and those values (0 m, 30 m) are displayed on the image 710.

Furthermore, by image capturing surface phase difference distance measurement based on the first range gate image signal (A) and the second range gate image signal (A) by the distance measuring unit 104, the distance to the pedestrian 830 is calculated as 5 m, and the calculated distance of 5 m is displayed on the image 710.

In FIG. 10B, the pedestrian 830 existing in the target distance range 1 (0 m to 30 m) is captured, and it is possible to accurately calculate the distance of the pedestrian 830. In contrast, the fog 810 and the vehicle 820 existing in the target distance range 2 (30 m to 60 m) are not captured.

Next, FIG. 10C shows the image 720 in the target distance range 2 (30 to 60 m) generated by the image capturing surface phase difference range gate distance measuring mode shown in FIG. 9B.

In the image 720, because the fog 810 is thinned by range gate control and the vehicle 820 can be captured as a clear image, the distance measuring unit 104 can accurately recognize and measure the distance.

The image 720 is subjected to recognition processing by the distance measuring unit 104, and the vehicle 820 is detected. In addition, by range gate control of the first photoelectric conversion unit 411 and the second photoelectric conversion unit 412 by the camera control unit 105, it is understood that the vehicle 820 corresponds to the target distance range 2 (30 m to 60 m), and those values (30 m, 60 m) are displayed on the image 720.

Furthermore, by image capturing surface phase difference distance measurement based on the first range gate image signal (B) and the second range gate image signal (B) by the distance measuring unit 104, the distance to the vehicle 820 is calculated as 40 m, and is displayed on the image 720. In contrast, in the image 720, the pedestrian 830 existing in the target distance range 1 (0 to 30 m) is not captured.

Next, FIG. 10D shows the composite image 730 in 0 to 60 m obtained by compositing the image 710 and the image 720. In addition, the composite image 730 has distance information of the image 710 and the image 720, and the distance range combined from the target distance range 1 and the target distance range 2 (0 m to 60 m) and the distance of the vehicle 820 and the pedestrian 830 are displayed.

Thereby, for example, a driver of the movable apparatus 200 who has visually recognized the composite image 730 can understand that the vehicle 820 exists beyond the fog 810 and that the vehicle 820 exists 40 m ahead. Furthermore, in a case in which the ECU 201 determines that emergency braking is necessary based on this distance measurement result, the ECU 201 can promptly instruct automatic braking to the vehicle control unit 202.

In addition, in the image capturing surface phase difference range gate distance measuring mode, the distance may be calculated by dividing the target distance range R in FIG. 6 into, for example, three or more ranges. In that case, the distance may be calculated after compositing image signals having less noise among each range gate image signal. By doing so, the number of distance calculation processing becomes smaller, and the load in distance measurement processing can be reduced.

In step S109, it is determined whether the movable apparatus 200 is in a traveling state, and in a case in which the movable apparatus 200 is in a traveling state, the process proceeds to step S101. In a case in which the movable apparatus 200 is not in a traveling state, the processing flow of FIG. 8 is ended.

As described above, in the present embodiment, processing for calculating the distance to the object based on the first photoelectric conversion signal and the second photoelectric conversion signal generated without range gate control is executed based on a determination result of the visibility condition determination unit. Alternatively, switching whether to execute processing for calculating the distance to the object based on the first photoelectric conversion signal and the second photoelectric conversion signal generated by range gate control is performed based on the above-described determination result.

It should be noted that, as explained using FIG. 6, with only range gate control of the photoelectric conversion element 102 and the light emitter 300, distance measurement of the object can only be performed in the target distance range R. In contrast, in the present embodiment, by performing range gate control of the light emitter 300, the first photoelectric conversion unit 411, and the second photoelectric conversion unit 412, and by performing distance measurement based on the image capturing surface phase difference method, the distance of the object can be accurately calculated in bad weather conditions.

<Second Embodiment>

Hereinafter, an explanation is provided with respect to the Second Embodiment of the present disclosure. It should be noted that, in the First Embodiment, an explanation was provided with respect to a method for accurately measuring distance to an object by performing range gate control of the light emission time of the light emitter 300 and the exposure time and the exposure timing of the photoelectric conversion element 102 for image capturing surface phase difference distance measurement.

In the Second Embodiment, an explanation is provided with respect to a method for improving parallax reliability accuracy acquired by range gate control of the photoelectric conversion element 102 for image capturing surface phase difference distance measurement based on the target distance range R acquired by range gate control.

Parallax reliability is an index indicating how much error is included in a calculated parallax value, and each pixel has parallax reliability. In addition, because a distance value is calculated based on parallax, parallax reliability is also an index indicating how much error is included in the distance value.

For example, a ratio of standard deviation to an average value of signal values included in a matching region can be evaluated as parallax reliability. When a change in signal values (contrast) within the matching region is large, the standard deviation becomes large.

In addition, in a case in which an amount of light incident on a pixel is large, the average value becomes large, and there is more noise. That is, the average value of the signal values has a positive correlation with the amount of noise. The ratio of standard deviation to the average value (standard deviation/average value) corresponds to a ratio of magnitude of contrast to the amount of noise.

If contrast is sufficiently large with respect to the amount of noise, it can be estimated that error in the calculated parallax value is small. That is, the larger the parallax reliability, the smaller the error in the calculated parallax value, and the parallax value can be said to be more accurate.

It should be noted that a functional block diagram in the Second Embodiment has the same configuration as FIG. 3, and the present embodiment is preferably implemented after step S108 in FIG. 8. However, the implementation is not limited thereto.

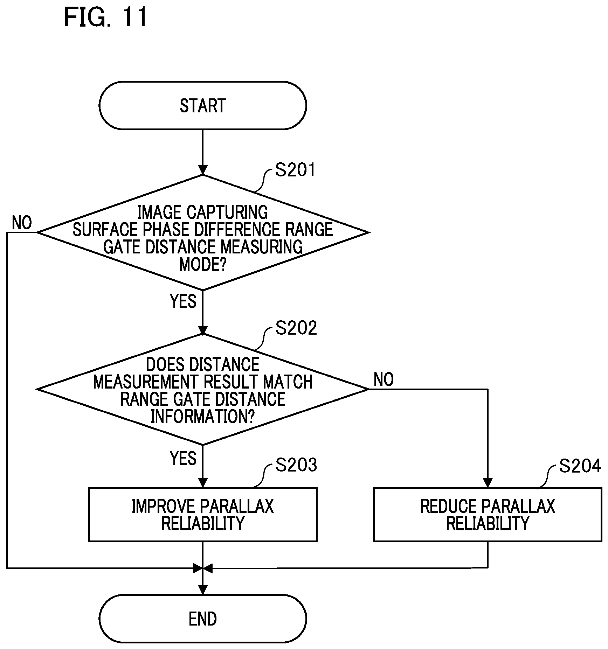

FIG. 11 is a flowchart showing an example of parallax reliability improvement processing in a distance measuring method according to the Second Embodiment. It should be noted that operations of each step of the flowchart of FIG. 11 are sequentially performed by a CPU and the like serving as a computer in the camera control unit 105 executing a computer program stored in the memory.

In step S201, the camera control unit 105 determines whether or not the distance measurement processing of the First Embodiment is in the image capturing surface phase difference range gate distance measuring mode. Specifically, the camera control unit 105 determines whether the process proceeded to step S103 after determining in step S 102 of FIG. 8 that bad weather conditions were not present ahead of the vehicle, or proceeded to step S105 after determining that bad weather conditions were present ahead of the vehicle.

In a case in which it is determined in step S201 that the process is not in the image capturing surface phase difference range gate distance measuring mode, the processing flow of FIG. 11 is ended, and in a case in which it is determined that the process is in the image capturing surface phase difference range gate distance measuring mode, the process proceeds to step S202.

In step S202, it is determined whether or not distance measurement results match range gate distance information. It should be noted that each pixel in a first range gate image signal (A), a second range gate image signal (A), a first range gate image signal (B), and a second range gate image signal (B) has target distance range R information.

Accordingly, the distance measuring unit 104 determines whether or not target distance range R information possessed by each pixel and distance values possessed by pixels corresponding to an object of the composite image 730 in the image capturing surface phase difference range gate distance measuring mode are in agreement. It should be noted that agreement in this context is determined as agreement even without complete agreement if values are within a predetermined allowable range.

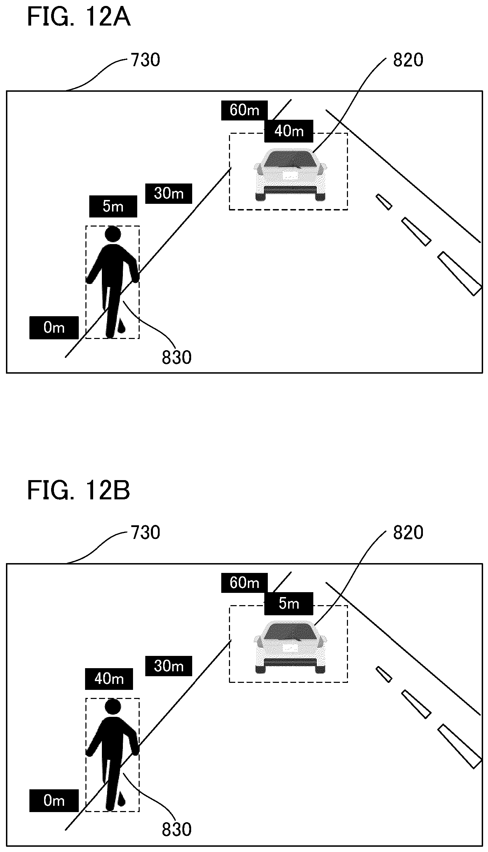

FIG. 12A and FIG. 12B are diagrams for explaining a method of determining whether target distance range R information in a range gate image signal according to the Second Embodiment and a distance measurement result of an object according to the image capturing surface phase difference range gate distance measuring mode are in agreement.

By using FIG. 12, an explanation is provided with respect to a method of determining whether or not target distance range R information in each pixel of each range gate image signal and distance measurement values in pixels corresponding to objects of the composite image 730 in the image capturing surface phase difference range gate distance measuring mode are in agreement.

FIG. 12A shows a case in which, in step S202, target distance range R information in each pixel of each range gate image signal and distance measurement values in pixels corresponding to objects of the composite image 730 in the image capturing surface phase difference range gate distance measuring mode are in agreement.

FIG. 12A is the composite image 730 shown in FIG. 10D. In FIG. 12A, each pixel in the composite image 730 contains distance information of target distance ranges R 0 m to 30 m and 30 m to 60 m by range gate control, and distance measurement values of an object calculated by the image capturing surface phase difference range gate distance measuring mode.

For example, in FIG. 12A, the distance measurement value of an object in the image capturing surface phase difference range gate distance measuring mode is calculated as 5 m for the pedestrian 830 with respect to the target distance range 0 m to 30 m. In addition, the distance measurement value of the vehicle 820 is calculated as 40 m with respect to the target distance range 30 m to 60 m. Accordingly, the distance measurement values are in agreement with each target distance range R information.

Thereby, the possibility that the pedestrian 830 exists at 5 m and the vehicle 820 exists at 40 m is high, and parallax reliability representing errors in distances of the pedestrian 830 and the vehicle 820 can be estimated to be high.

In a case in which target distance range R information in each pixel of each range gate image signal and distance measurement values in pixels corresponding to objects of the composite image 730 in the image capturing surface phase difference range gate distance measuring mode are in agreement, the process proceeds to step S203.

In step S203, the distance measuring unit 104 increases parallax reliability in the composite image 730. Methods of increasing a parallax reliability value in the composite image 730 include adding a constant X greater than 0 to the parallax reliability, or multiplying by a variable Y greater than 1. However, the methods are not limited thereto.

In this manner, in the present embodiment, parallax reliability is updated based on the distance to the object calculated based on the first photoelectric conversion signal and the second photoelectric conversion signal generated by performing range gate control.

FIG. 12B shows a case in which, in step S202, target distance range R information in each pixel of each range gate image signal and distance measurement values in pixels corresponding to objects of the composite image 730 in the image capturing surface phase difference range gate distance measuring mode are not in agreement.

FIG. 12B is, similar to FIG. 12A, the composite image 730 of FIG. 10D. In FIG. 12B, each pixel in the composite image 730 contains distance information of target distance ranges R 0 m to 30 m and 30 m to 60 m by range gate control and distance information of objects calculated by the image capturing surface phase difference range gate distance measuring mode.

For example, in FIG. 12B, the distance measurement result of an object by the image capturing surface phase difference range gate distance measuring mode is 40 m for the pedestrian 830 with respect to the target distance range 0 m to 30 m. In addition, the distance measurement value of the vehicle 820 is calculated as 20 m with respect to the target distance range 30 m to 60 m, and the distance measurement values are not in agreement with each target distance range R information.

Accordingly, the possibility that the pedestrian 830 exists at 5 m and the vehicle 820 exists at 40 m is low, and parallax reliability representing errors in distances of the pedestrian 830 and the vehicle 820 can be estimated to be low.

In a case in which target distance range R information in each pixel of each range gate image signal and distance measurement values in pixels corresponding to objects of the composite image 730 in the image capturing surface phase difference range gate distance measuring mode are not in agreement, the process proceeds to step S204.

In step S204, the distance measuring unit 104 decreases parallax reliability in the composite image 730. Methods of decreasing a parallax reliability value in the composite image 730 include subtracting a constant X greater than 0 from the parallax reliability, or multiplying by a variable Y less than 1. However, the methods are not limited thereto.

In this manner, determination is made as to whether or not distance measurement values acquired by range gate control of the photoelectric conversion element 102 for image capturing surface phase difference distance measurement are in agreement with target distance range R acquired by range gate control. Then, by changing the parallax reliability according to the result, the accuracy of parallax reliability can be improved.

<Third Embodiment>

Hereinafter, an explanation is provided with respect to the Third Embodiment of the present disclosure. In the First Embodiment, an explanation was provided with respect to a configuration in which the photoelectric conversion element 102 is a CMOS sensor. In the Third Embodiment, an explanation is provided with respect to a configuration in which the photoelectric conversion element 102 includes an avalanche photodiode (hereinafter, "APD").

The photoelectric conversion element 102 including the APD can digitally count the number of incident photons and output the count value from the pixel as a photoelectrically converted digital signal. Unlike CMOS sensors, the photoelectric conversion element 102 including the APD can quickly switch the exposure time ON/OFF.

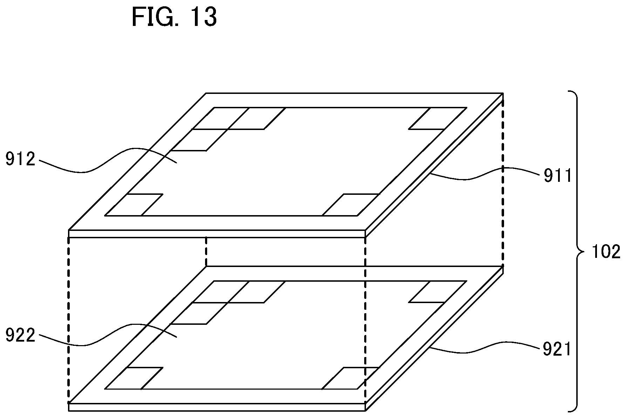

In addition, because the APD has no readout noise, the original signal does not deteriorate even when read out multiple times with a single accumulation. An explanation is provided with respect to the configuration and operation of the photoelectric conversion element 102 that is provided with the APD by using FIG. 13 to FIG. 16.

FIG. 13 is a diagram showing a configuration example of the photoelectric conversion element 102 according to the Third Embodiment. Hereinafter, an explanation is provided with respect to an example of a photoelectric conversion element having a so-called stacked structure in which the photoelectric conversion element 102 has two substrates, a sensor substrate 911 and a circuit substrate 921, that are stacked and electrically connected.

However, the photoelectric conversion element may have a so-called non-stacked structure in which configurations included in the sensor substrate and configurations included in the circuit substrate are arranged in a common semiconductor layer. The sensor substrate 911 includes a pixel region 912. The circuit substrate 921 includes a circuit region 922 that processes signals detected in the pixel region 912.

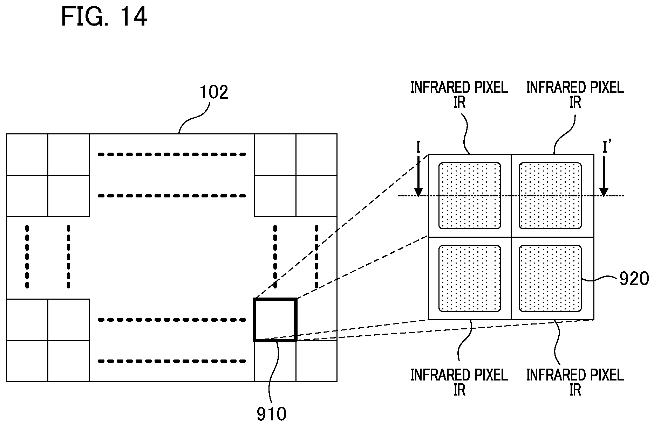

FIG. 14 is a schematic diagram showing a configuration example of the photoelectric conversion element 102 including the APD, and is a plan view of the photoelectric conversion element 102 viewed from a light incident direction. The photoelectric conversion element 102 is configured by arranging a plurality of 2 row × 2 column pixel groups 910 in a matrix. The pixel group 910 has four infrared pixels IR that detect IR (infrared) light.

It should be noted that the arrangement of each pixel in the pixel group 910 is not limited thereto, and may be changed according to a wavelength band of light emitted from the light emitter 300. That is, the pixel group 910 may be configured by, for example, an infrared pixel IR that detects IR light, a red pixel that detects red color, a green pixel that detects green light, and a blue pixel that detects blue light.

In addition, the pixel group 910 may be configured by two green pixels that detect green color, a red pixel that detects red color, and a blue pixel that detects blue light. In a case in which the above-described pixel arrangement is used, the two green pixels are arranged diagonally. In addition, each pixel is provided with a photoelectric conversion unit 920.

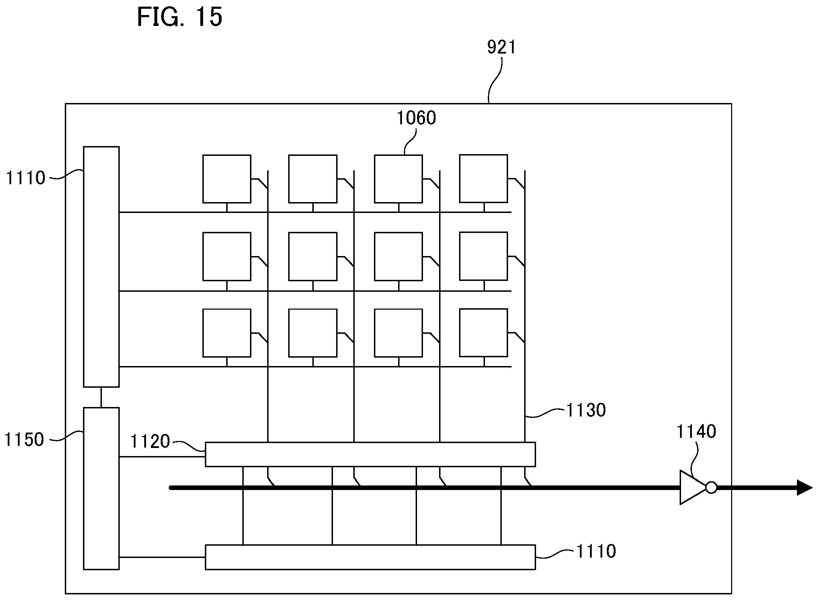

FIG. 15 is a diagram showing a configuration example of the circuit substrate 921. The circuit substrate 921 includes a signal processing circuit 1060 configured to process charge photoelectrically converted by the pixels shown in FIG. 14, a readout circuit 1120, a control pulse generation unit 1150, a horizontal scanning circuit 1100, a vertical signal line 1130, a vertical scanning circuit 1110, and an output circuit 1140.

The vertical scanning circuit 1110 receives a control pulse supplied from the control pulse generation unit 1150, and sequentially supplies a control pulse to a plurality of pixels arranged in a row direction on a row-by-row basis. A logic circuit such as a shift register and an address decoder is used for the vertical scanning circuit 1110.

A signal output from the photoelectric conversion unit 920 of each pixel is processed in each signal processing circuit 1060. The signal processing circuit 1060 is provided with a counter, a memory, and the like, and a digital value is held in the memory.

The horizontal scanning circuit 1100 inputs to the signal processing circuit 1060 a control pulse that sequentially selects each column in order to read out a signal from the memory of each pixel in which a digital signal is held.

Signals are output to the vertical signal line 1130 from the signal processing circuits 1060 of pixels in a row selected by the vertical scanning circuit 1110. The signal output to the vertical signal line 1130 is output to the outside of the photoelectric conversion element 102 via the readout circuit 1120 and the output circuit 1140. The signal processing circuit 1060 incorporates a plurality of buffers connected to the vertical signal line 1130.

As shown in FIG. 13 and FIG. 15, in a plan view, the circuit region 922 is arranged in a region overlapping the pixel region 912. Then, in a plan view, the vertical scanning circuit 1110, the horizontal scanning circuit 1100, the readout circuit 1120, the output circuit 1140, and the control pulse generation unit 1150 are arranged so as to overlap a peripheral region outside of the pixel region 912 of the sensor substrate 911.

That is, the sensor substrate 911 includes the pixel region 912 and a non-pixel region arranged around the pixel region 912. Then, in a plan view, the vertical scanning circuit 1110, the horizontal scanning circuit 1100, the readout circuit 1120, the output circuit 1140, and the control pulse generation unit 1150 are arranged in a region overlapping the non-pixel region.

It should be noted that arrangement of the vertical signal line 1130 and the arrangement of the readout circuit 1120 and the output circuit 1140 are not limited to the example shown in FIG. 15. For example, the vertical signal line 1130 may be arranged extending in the row direction, and the readout circuit 1120 may be arranged at the terminal end of the vertical signal line 1130.

In addition, the signal processing circuit 1060 need not necessarily be provided one-to-one for each photoelectric conversion unit, and may instead be configured such that one signal processing unit is shared among a plurality of photoelectric conversion units and performs sequential signal processing.

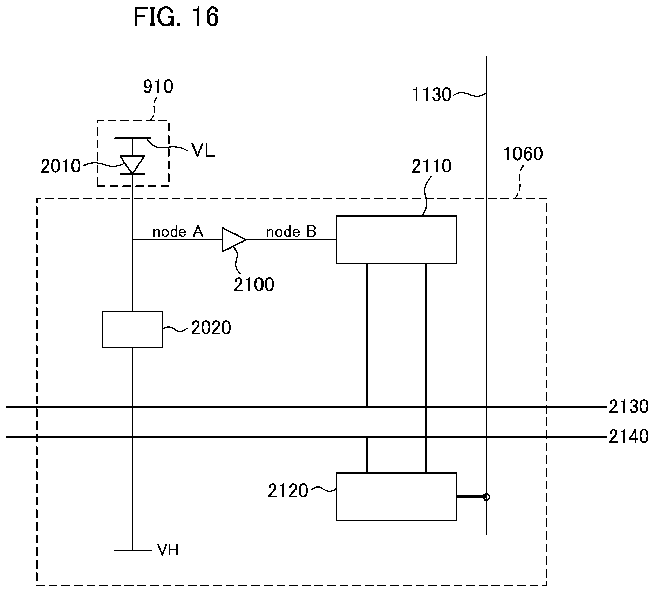

FIG. 16 is a diagram showing an example of an equivalent circuit of the signal processing circuit 1060 according to the Third Embodiment, and shows an example of an equivalent circuit of the signal processing circuit 1060 corresponding to each pixel of the pixel group 910 in FIG. 13 and FIG. 15.

It should be noted that FIG. 16 explains one APD, and the first photoelectric conversion unit and the second photoelectric conversion unit of the First Embodiment are each assumed to be configured by an APD. That is, two instances of the configuration shown in FIG. 16 are arranged for each pixel.

That is, the first photoelectric conversion unit and the second photoelectric conversion unit are each provided with an APD configured to generate a pulse according to photons, a counter that counts a number of pulses, and a memory that stores a count value of the counter.

The APD 2010 included in the photoelectric conversion unit 920 generates an electron-hole pair according to incident light by photoelectric conversion. One of two nodes of the APD 2010 is connected to a power supply line to which a driving voltage VL (first voltage) is supplied.

In addition, the other of the two nodes of the APD 2010 is connected to a power supply line to which a driving voltage VH (second voltage) higher than the driving voltage VL is supplied via a quench element 2020.

In FIG. 16, one node of the APD 2010 is an anode, and the other node of the APD is a cathode. A reverse bias voltage such that the APD 2010 performs avalanche multiplication operation is supplied to the anode and the cathode of the APD 2010.

By establishing a state in which such a voltage is supplied, charge generated by incident light causes avalanche multiplication, and avalanche current is generated.

It should be noted that, in a case in which a reverse bias voltage is supplied, there is a Geiger mode that operates at a voltage difference larger than a breakdown voltage between the anode and the cathode, and a linear mode that operates at a voltage difference in the vicinity of the breakdown voltage or at a voltage difference equal to or less than the breakdown voltage.

An APD operated in the Geiger mode is called an SPAD. In the case of an SPAD, for example, the driving voltage VL (first voltage) is -30 V, and the driving voltage VH (second voltage) is 1 V. It should be noted that an SPAD is included as a type of APD.

The signal processing circuit 1060 includes the quench element 2020, a wave shaping unit 2100, a counter circuit 2110, and a memory circuit 2120. The quench element 2020 is connected to a power supply line to which the driving voltage VH is supplied and to one of the nodes, the anode or the cathode, of the APD 2010.

The quench element 2020 functions as a load circuit (quench circuit) during signal amplification by avalanche multiplication, and has a function of suppressing avalanche multiplication by suppressing a voltage supplied to the APD 2010 (quench operation).

In addition, the quench element 2020 has a function of returning a voltage supplied to the APD 2010 to the driving voltage VH by flowing a current corresponding to a portion that dropped in voltage during the quench operation (recharge operation).

An example is shown in FIG. 16 in which the signal processing circuit 1060 includes the wave shaping unit 2100, the counter circuit 2110, and the memory circuit 2120 in addition to the quench element 2020.

The wave shaping unit 2100 shapes a voltage change of the cathode of the APD 2010 obtained upon detection of a photon, and outputs a pulse signal. For example, an inverter circuit is used as the wave shaping unit 2100.

In FIG. 16, an example using one inverter as the wave shaping unit 2100 is shown, and a circuit in which a plurality of inverters are connected in series may be used, or another circuit having a waveform shaping effect may be used.

The counter circuit 2110 counts a number of pulses output from the wave shaping unit 2100, and holds a count value. In addition, when a control pulse RES is supplied via a drive line 2130, a signal held in the counter circuit 2110 is reset. Here, the counter circuit 2110 generates a signal based on a difference between count values at a start time and an end time of an accumulation period.

A control pulse SEL is supplied to the memory circuit 2120 from the vertical scanning circuit 1110 of FIG. 15 via a drive line 2140 (not shown in FIG. 15), and electrical connection and non-connection between the memory circuit 2120 and the vertical signal line 1130 are switched.

The memory circuit 2120 functions as a memory configured to temporarily store a count value of the counter, and output an output signal from the counter circuit 2110 of the pixel to the vertical signal line 1130 via the memory circuit 2120.

It should be noted that a switch such as a transistor may be arranged between the quench element 2020 and the APD 2010, or between the photoelectric conversion unit 920 and the signal processing circuit 1060, and electrical connection may be switched. Similarly, supply of the driving voltage VH or the driving voltage VL supplied to the photoelectric conversion unit 920 may be electrically switched by using a switch such as a transistor.

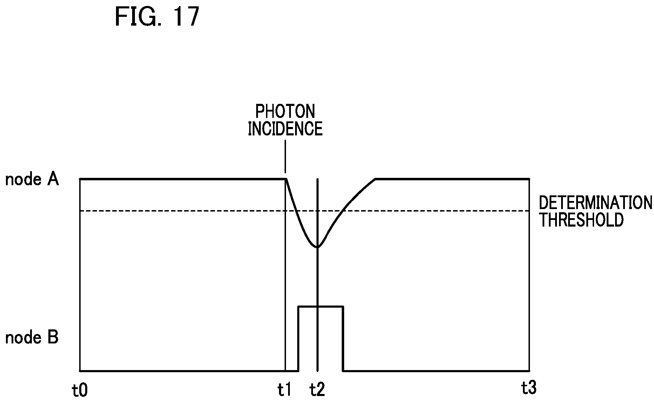

FIG. 17 is a diagram schematically showing a relationship of operation and output signal of the APD 2010. An input side of the wave shaping unit 2100 is denoted as "node A", and an output side is denoted as "node B". In a period from time to to time t1, a potential difference of VH-VL is applied to the APD 2010.

When a photon is incident on the APD 2010 at time t1, avalanche multiplication occurs in the APD 2010, and avalanche multiplication current flows to the quench element 2020, and voltage of node A drops.

When the amount of voltage drop becomes larger, and the potential difference applied to the APD 2010 becomes smaller, the avalanche multiplication of the APD 2010 stops as occurs at time t2, and the voltage level of node A no longer drops below a certain value.

Thereafter, in a period from time t2 to time t3, current that compensates for the voltage drop from the driving voltage VL flows to node A, and at time t3, node A settles to the original potential level. At this time, a portion at which an output waveform at node A falls below a threshold value is wave-shaped by the wave shaping unit 2100, and is output as a pulse signal at node B. The above is an explanation with respect to the configuration and operation of the APD.

In this manner, in the present embodiment, by performing range gate control of the photoelectric conversion element 102 including the APD and the light emitter 300, a range gate image signal having less noise compared to a CMOS sensor can be acquired.

Accordingly, in the image capturing surface phase difference range gate distance measurement described in the First Embodiment, by measuring distance to an object based on a range gate image having less noise, calculation of a distance value of higher accuracy becomes possible.

In addition, by performing range gate control of the photoelectric conversion element 102 including the APD and the light emitter 300, because the exposure time width of the photoelectric conversion element 102 can be controlled so as to be shorter, the target distance range R can be made smaller compared to a CMOS sensor. That is, by making the target distance range R smaller, distance resolution can be increased, and distance accuracy can be improved.

It should be noted that, in the above-described embodiment, although the movable apparatus 200 was explained by using an example of a vehicle such as an automobile and the like, the movable apparatus may be any object capable of movement, such as an aircraft, a train, a ship, a drone, an AGV, a robot, and the like.

While the present disclosure has been described with reference to embodiments, it is to be understood that the disclosure is not limited to the disclosed embodiments. The scope of the following claims is to be accorded the broadest interpretation so as to encompass all such modifications and equivalent structures and functions.

In addition, as a part or the whole of the control according to the embodiments, a computer program realizing the function of the embodiments described above may be supplied to the distance measuring apparatus and the like through a network or various storage media. Then, a computer (or a CPU, an MPU, or the like) of the distance measuring apparatus and the like may be configured to read and execute the program. In such a case, the program and the storage medium storing the program configure the present invention.

In addition, the present disclosure includes those realized using at least one processor or circuit configured to perform functions of the embodiments explained above. For example, a plurality of processors may be used for distribution processing to perform functions of the embodiments explained above.

This application claims the benefit of Japanese Patent Application No. 2024-153685, filed on September 6, 2024, which is hereby incorporated by reference herein in its entirety.

**Claims**

1. A distance measuring apparatus comprising:

   a light emitter configured to emit pulsed light in a traveling direction of a movable apparatus;
   a photoelectric conversion element having a plurality of pixels arranged, each pixel having a first photoelectric conversion unit configured to generate a first photoelectric conversion signal and a second photoelectric conversion unit configured to generate a second photoelectric conversion signal, wherein the first photoelectric conversion signal and the second photoelectric conversion signal have a predetermined parallax; and
   a visibility condition determination means for determining a visibility condition of the traveling direction; and
   a control means for performing range gate control of a light emission time of the light emitter, and an exposure time and an exposure timing of the photoelectric conversion element;
   wherein the control means switches, based on a determination result of the visibility condition determination means, between executing processing for calculating a distance to an object based on the first photoelectric conversion signal and the second photoelectric conversion signal generated without performing the range gate control, and executing processing for calculating a distance to an object based on the first photoelectric conversion signal and the second photoelectric conversion signal generated by the range gate control.

2. The distance measuring apparatus according to claim 1, wherein the control means is configured to update a parallax reliability based on a distance to an object calculated based on the first photoelectric conversion signal and the second photoelectric conversion signal generated by performing the range gate control.

3. The distance measuring apparatus according to claim 1 or claim 2, wherein the control means is configured to add a plurality of first photoelectric conversion signals generated by performing the range gate control a plurality of times, and to add a plurality of second photoelectric conversion signals generated by performing the range gate control a plurality of times.

4. The distance measuring apparatus according to any one of claims 1 to 3, wherein the first photoelectric conversion unit and the second photoelectric conversion unit each comprise:

 an APD configured to generate pulses according to photons;
 a counter configured to count a number of the pulses; and
 a memory configured to store a count value of the counter.

5. The distance measuring apparatus according to any one of claims 1 to 4, wherein light emitted by the light emitter is visible light or non-visible light.

6. A method for measuring distance using a distance measuring apparatus, the distance measuring apparatus comprising:

 a light emitter configured to emit pulsed light in a traveling direction of a movable apparatus;
 a photoelectric conversion element having a plurality of pixels arranged, each pixel having a first photoelectric conversion unit configured to generate a first photoelectric conversion signal and a second photoelectric conversion unit configured to generate a second photoelectric conversion signal, wherein the first photoelectric conversion signal and the second photoelectric conversion signal have a predetermined parallax; and
 the distance measuring method comprising:

  determining a visibility condition of the traveling direction;
  performing range gate control of a light emission time of the light emitter, and an exposure time and an exposure timing of the photoelectric conversion element; and
  switching based on the visibility condition of the traveling direction, whether to execute processing for calculating a distance to an object based on the first photoelectric conversion signal and the second photoelectric conversion signal generated without performing the range gate control, or to execute processing for calculating a distance to an object based on the first photoelectric conversion signal and the second photoelectric conversion signal generated by the range gate control.

7. A computer program to control a distance measuring apparatus, wherein the distance measuring apparatus comprises:

 a light emitter configured to emit pulsed light in a traveling direction of a movable apparatus;
 a photoelectric conversion element having a plurality of pixels arranged, each pixel having a first photoelectric conversion unit configured to generate a first photoelectric conversion signal and a second photoelectric conversion unit configured to generate a second photoelectric conversion signal, wherein the first photoelectric conversion signal and the second photoelectric conversion signal have a predetermined parallax; and
 wherein the computer program comprises instructions for executing the following process:

  determining a visibility condition of the traveling direction;
  performing range gate control of a light emission time of the light emitter, and an exposure time and an exposure timing of the photoelectric conversion element; and
  switching based on the visibility condition of the traveling direction, whether to execute processing for calculating a distance to an object based on the first photoelectric conversion signal and the second photoelectric conversion signal generated without performing the range gate control, or to execute processing for calculating a distance to an object based on the first photoelectric conversion signal and the second photoelectric conversion signal generated by the range gate control.

FIG. 1A

FIG. 1B

FIG. 1C

FIG. 1D

FIG. 2A

200

300

FIG. 2B

300

200

FIG. 2C

200

300

FIG. 3

CAMERA 100

101 IMAGING OPTICAL SYSTEM

102 PHOTOELECTRIC CONVERSION ELEMENT

103 IMAGE PROCESSING UNIT

104 DISTANCE MEASURING UNIT

105 CAMERA CONTROL UNIT

106 STORAGE UNIT

107 COMMUNICATION UNIT

108 BAD WEATHER DETERMINATION UNIT

200

201 ECU

202 VEHICLE CONTROL UNIT

203 DISPLAY UNIT

LIGHT EMITTER 300

301 LIGHT EMITTING UNIT

302 LIGHT EMISSION CONTROL UNIT

303 COMMUNICATION UNIT

# FIG. 4A

102

INFRARED PIXEL IR    INFRARED PIXEL IR

I    I'

411

412

400

INFRARED PIXEL IR    INFRARED PIXEL IR

# FIG. 4B

INFRARED PIXEL IR1    INFRARED PIXEL IR2

413

414

415

401  402

## FIG. 5A

## FIG. 5B

## FIG. 5C

## FIG. 5D

# FIG. 6

EP 4 707 857 A1

## FIG. 7

EP 4 707 857 A1

FIG. 8

```
                    ┌─────────────┐
                    │    START    │
                    └──────┬──────┘
                           │
                           ▼           ⌒S101
              ┌────────────────────────┐
              │   ACQUIRE WEATHER       │
              │   INFORMATION AHEAD     │
              │      OF VEHICLE         │
              └────────────┬───────────┘
                           │
                           ▼           ⌒S102
                      ╱─────────╲
                     ╱ BAD WEATHER?╲──────── NO ───────┐
                      ╲─────────╱                       │
                           │                            │
                          YES        ⌒S105              │        ⌒S103
              ┌────────────────────────┐   ┌────────────────────────┐
              │ START IMAGE CAPTURING   │   │ START IMAGE CAPTURING   │
              │ SURFACE PHASE DIFFERENCE│   │ SURFACE PHASE DIFFERENCE│
              │ RANGE GATE DISTANCE     │   │ DISTANCE MEASURING MODE │
              └────────────┬───────────┘   └────────────┬───────────┘
                           │    ⌒S106                    │    ⌒S104
              ┌────────────────────────┐   ┌────────────────────────┐
              │  ACQUIRE RANGE GATE     │   │   ACQUIRE IMAGE SIGNAL  │
              │    IMAGE SIGNAL         │   │                         │
              └────────────┬───────────┘   └────────────┬───────────┘
                           │                            │
                           └──────────────┬─────────────┘
                                          ▼
                              ┌────────────────────┐  ⌒S107
                              │  IMAGE PROCESSING   │
                              └──────────┬─────────┘
                                         │
                                         ▼
              ┌────────────────────────────────────────────┐ ⌒S108
              │ CALCULATE PARALLAX AMOUNT, CONVERT          │
              │ TO DISTANCE VALUE, GENERATE IMAGE           │
              │ BASED ON DISTANCE VALUE                     │
              └───────────────────┬────────────────────────┘
                                  │
                                  ▼              ⌒S109
                            ╱───────────╲
          NO ──────────────╱DRIVING FINISHED?╲
                            ╲───────────╱
                                  │
                                 YES
                                  ▼
                          ┌─────────────┐
                          │     END     │
                          └─────────────┘
```

## FIG. 9A

VERTICAL SYNCHRONIZATION SIGNAL (FRAME PERIOD)

1 FRAME TIME

LIGHT EMISSION CONTROL

...

EXPOSURE CONTROL OF FIRST PHOTOELECTRIC CONVERSION UNIT

...

EXPOSURE CONTROL OF SECOND PHOTOELECTRIC CONVERSION UNIT

...

200 ns
400 ns

## FIG. 9B

VERTICAL SYNCHRONIZATION SIGNAL (FRAME PERIOD)

1 FRAME TIME

LIGHT EMISSION CONTROL

...

EXPOSURE CONTROL OF FIRST PHOTOELECTRIC CONVERSION UNIT

...

EXPOSURE CONTROL OF SECOND PHOTOELECTRIC CONVERSION UNIT

...

200 ns
600 ns

EP 4 707 857 A1

FIG. 10A

FIG. 10B

FIG. 10C

FIG. 10D

EP 4 707 857 A1

# FIG. 11

```
                    ┌──────────────────────┐
                    │        START         │
                    └──────────┬───────────┘
                               │        ┌─S201
                               ▼
         NO            ◇─────────────────────◇
        ┌─────────────   IMAGE CAPTURING
        │              SURFACE PHASE DIFFERENCE RANGE
        │               GATE DISTANCE MEASURING
        │                      MODE?
        │              ◇─────────────────────◇
        │                      │ YES
        │                      │        ┌─S202
        │                      ▼
        │            ◇─────────────────────◇
        │                 DOES DISTANCE            NO
        │            MEASUREMENT RESULT MATCH  ─────────────┐
        │               RANGE GATE DISTANCE                 │
        │                  INFORMATION?                     │
        │            ◇─────────────────────◇                │
        │                      │ YES                        │
        │                      │   ┌─S203           ┌─S204  │
        │                      ▼                            ▼
        │         ┌─────────────────────┐     ┌─────────────────────┐
        │         │  IMPROVE PARALLAX    │     │   REDUCE PARALLAX    │
        │         │     RELIABILITY      │     │     RELIABILITY      │
        │         └──────────┬──────────┘     └──────────┬──────────┘
        │                    │                           │
        └────────────────────►◄──────────────────────────┘
                             │
                             ▼
                    ┌──────────────────────┐
                    │         END          │
                    └──────────────────────┘
```

## FIG. 12A

## FIG. 12B

FIG. 13

FIG. 14

INFRARED PIXEL IR     INFRARED PIXEL IR

102

I     I'

920

910

INFRARED PIXEL IR     INFRARED PIXEL IR

EP 4 707 857 A1

FIG. 15

FIG. 16

FIG. 17

PHOTON
INCIDENCE

node A

DETERMINATION
THRESHOLD

node B

t0          t1  t2          t3

Europäisches
Patentamt

European
Patent Office

Office européen
des brevets

## EUROPEAN SEARCH REPORT

**Application Number**

EP 25 19 8932

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2023/132616 A1 (ZHOU YILUN [CN] ET AL) 4 May 2023 (2023-05-04) * figure 6 * * paragraph [0033] * * paragraph [0038] * * paragraph [0049] - paragraph [0054] * ----- | 1-7 | INV. G01S7/4863 G01S17/14 G01S17/18 G01S17/894 G01S17/931 H04N25/773 H10F77/00 |
| A | US 2016/156867 A1 (FUKUDA KOICHI [JP]) 2 June 2016 (2016-06-02) * figure 7 * * paragraph [0064] - paragraph [0071] * ----- | 1-7 | |
| A | US 2022/236415 A1 (KIM JUNGWOO [KR] ET AL) 28 July 2022 (2022-07-28) * paragraph [0055] - paragraph [0066] * * paragraph [0098] - paragraph [0099] * ----- | 1-7 | |

**TECHNICAL FIELDS SEARCHED (IPC)**

G01S
H04N
H10F

The present search report has been drawn up for all claims

| Place of search | Date of completion of the search | Examiner |
|---|---|---|
| Munich | 7 January 2026 | Töpfer, Nils-Peter |

CATEGORY OF CITED DOCUMENTS

X : particularly relevant if taken alone
Y : particularly relevant if combined with another
 document of the same category
A : technological background
O : non-written disclosure
P : intermediate document

T : theory or principle underlying the invention
E : earlier patent document, but published on, or
 after the filing date
D : document cited in the application
L : document cited for other reasons
...................................................................................................
& : member of the same patent family, corresponding
 document

EPO FORM 1503 03.82 (P04C01)

## ANNEX TO THE EUROPEAN SEARCH REPORT
## ON EUROPEAN PATENT APPLICATION NO.

EP 25 19 8932

This annex lists the patent family members relating to the patent documents cited in the above-mentioned European search report.
The members are as contained in the European Patent Office EDP file on
The European Patent Office is in no way liable for these particulars which are merely given for the purpose of information.

07-01-2026

| Patent document cited in search report | | Publication date | Patent family member(s) | | Publication date |
|---|---|---|---|---|---|
| US 2023132616 A1 | | 04-05-2023 | CN | 113866781 A | 31-12-2021 |
| | | | US | 2023132616 A1 | 04-05-2023 |
| | | | WO | 2022001228 A1 | 06-01-2022 |
| US 2016156867 A1 | | 02-06-2016 | NONE | | |
| US 2022236415 A1 | | 28-07-2022 | NONE | | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6293134 B
- JP 2008033872 A

- JP 2024153685 A